# EUROPÄISCHE PATENTSCHRIFT

(11) **EP 2 343 804 B1**
(45) Veröffentlichungstag und Bekanntmachung des Hinweises auf die Patenterteilung: **29.07.2020**
(21) Anmeldenummer: 10192542.8
(22) Anmeldetag: 25.11.2010
(51) Int. Cl.: H03K 17/082

(54) **Schaltungsanordnung für Leistungshalbleiterbauelemente**
Circuit assembly for power semiconductor components
Agencement de commutation pour composants semi-conducteurs de puissance

(30) Priorität: 05.01.2010 DE 102010000691
(43) Veröffentlichungstag der Anmeldung: 13.07.2011
(73) Patentinhaber: Semikron Elektronik GmbH & Co. KG Patentabteilung, 90431 Nürnberg (DE)
(72) Erfinder: Schuler, Stefan, 91052 Erlangen (DE)

(56) Entgegenhaltungen:
- EP-A2- 0 772 288
- US-B1- 6 208 041

## Beschreibung

Die Erfindung betrifft eine Schaltungsanordnung für Leistungshalbleiterbauelemente.

Solche Schaltungsanordnungen werden insbesondere zur Herstellung von Stromumrichtern verwendet. Dabei sind mehrere parallel geschaltete Leistungshalbleiterbauelemente mit einem Treiber über zumindest eine erste Leitung bzw. in der Regel eine Gateleitung verbunden. Der Treiber schaltet die Leistungshalbleiterbauelemente gleichzeitig. Er wird über eine Steuerschaltung angesteuert.

Bei der Verwendung moderner Leistungshalbleiterbauelemente, wie IGBTs, ergeben sich wegen deren hoher Schaltgeschwindigkeit verschiedene technische Probleme. Diese werden z. B. in EP 0 961 379 B1 in den Absätzen [0002] bis [0017] beschrieben. Insbesondere bei relativ lang ausgebildeten Gateleitungen ergeben sich parasitäre Induktivitäten. Infolgedessen werden in die Gateleitung eingekoppelte Störsignale nicht ausreichend unterdrückt. Bei den Störsignalen handelt es sich meist um Spannungsspitzen. Abgesehen davon können in die Gateleitungen Spannungen induziert werden, welche durch die beim Schalten entstehenden starken Magnetfelder entstehen. Solche Spannungen führen mitunter zu Asymmetrien im Schaltverhalten der einzelnen Leistungshalbleiterbauelemente.

Zur Überwindung dieser technischen Problemen wird nach der EP 0 961 379 B1 vorgeschlagen, zumindest zwei Betriebsparameter der Leistungshalbleiterbauelemente zu messen und die gemessenen Betriebsparameter mit einem weiteren errechneten Parameter zu einem Kennfeld zu kombinieren. Die Daten des Kennfelds werden durch eine analoge Signalverarbeitung kontinuierlich bewertet. Falls sich aus der Bewertung eine bevorstehende Überlastung ergibt, werden mittels der übergeordneten Steuerschaltung die Parameter der Ansteuerung geändert, um der Überlastung und einem Abschalten entgegenzuwirken. Die Steuerschaltung muss also spezifisch zur Erfassung und Verarbeitung der durch die analoge Signalverarbeitung gelieferten Daten ausgestaltet sein.

Aus der EP 0 772 288 A2 ist ein System, bestehend aus einer Mehrzahl parallel geschalteter Leistungshalbleitermodule mit einem Halbleiterleistungsschaltelement zum Schalten eines Hauptstroms und einer Steuerschaltung zum Steuern des Elements und einer Schutzschaltung zum Schützen des Elements vor Schaden im Fall eines fehlerhaften Zustands, bekannt.

Aufgabe der Erfindung ist es, die Nachteile nach dem Stand der Technik zu beseitigen. Es soll insbesondere eine Schaltungsanordnung für Leistungshalbleiterbauelemente angegeben werden, die möglichst langlebig ist. Dabei soll die Langlebigkeit der Schaltungsanordnung insbesondere auch bei einer Kombination mit einer Steuerschaltung erreicht werden, welche für diesen Zweck nicht besonders hergerichtet ist. Nach einem weiteren Ziel der Erfindung soll ein Verfahren zum Betreiben einer Leistungshalbleiterschaltung angegeben werden, mit dem die Lebensdauer der Leistungshalbleiterschaltung verlängert werden kann.

Diese Aufgabe wird durch die Merkmale der Ansprüche 1 und 14 gelöst. Zweckmäßige Ausgestaltungen der Erfindung ergeben sich aus den Merkmalen der Ansprüche 2 bis 13 und 15 bis 24.

Nach Maßgabe der Erfindung wird eine Schaltungsanordnung für Leistungshalbleiterbauelemente vorgeschlagen, umfassend
mehrere Module, bei denen jeweils ein Treiber mit zumindest einem Leistungshalbleiterbauelement über zumindest eine erste Leitung verbunden ist,
wobei eine mit den Treibern über zweite Leitungen verbundene Schaltzeitpunktschaltung vorgesehen ist, mit der für jeden der Treiber ein individuelles Schaltsignal erzeugbar ist, wobei jedes der Schaltsignale für den jeweiligen Treiber individuell bezüglich des Schaltzeitpunkts, wobei die Schaltzeitpunktschaltung zur Erzeugung der individuellen Schaltsignale in Abhängigkeit eines Steuersignals betreibbar ist, wobei zumindest einige der Schaltsignale mit einem vorgegebenen individuellen Schalt-Offset erzeugbar sind, wobei der jeweilige Schalt-Offset so gewählt ist, dass ein sich ergebendes asynchrones Schaltverhalten der Leistungshalbleiterbauelemente korrigiert wird.

Das erfindungsgemäß vorgeschlagene Vorsehen der Schaltzeitpunktschaltung ermöglicht es, die Treiber individuell, insbesondere zu unterschiedlichen Zeitpunkten, zum Ein- und Ausschalten der Leistungshalbleiterbauelemente anzusteuern. Damit können Asymmetrien im Schaltverhalten der einzelnen Leistungshalbleiterbauelemente kompensiert werden. Abgesehen davon ist es möglich, die Leistungshalbleiterbauelemente auch in Abhängigkeit anderer Parameter so zu schalten, dass insgesamt die Lebensdauer der Schaltungsanordnung verlängert wird.

Die erfindungsgemäßen Module können in einem Leistungsteil der Schaltungsanordnung zusammengefasst sein. Jedes der Module umfasst einen Treiber, dem zweckmäßigerweise mehrere Leistungshalbleiterbauelemente zugeordnet sind. Ferner ist zur Ansteuerung der Treiber eine Schaltzeitpunktschaltung vorgesehen. Die Schaltzeitpunktschaltung ist zweckmäßigerweise ebenfalls Bestandteil des Leistungsteils. Sie erhält Steuersignale von einer damit verbunden Steuerschaltung, die in herkömmlicher Weise ausgebildet sein kann.

Die von der Steuerschaltung gelieferten Steuersignale werden mittels der Schaltzeitpunktschaltung in eine der Anzahl der Treiber entsprechende Anzahl an Schaltsignalen gewandelt. Dabei ist jedes der Schaltsignale für den jeweiligen Treiber individuell bezüglich des Schaltzeitpunkts und/oder der Schaltdauer.

Die mit der Schaltzeitpunktschaltung erzeugten Schaltsignale können vorteilhafterweise zeitlich so aufeinander abgestimmt sein, dass zumindest eine den Schaltzeitpunkt der Leistungshalbleiterbauelemente beeinflussende Größe kompensierbar und ein zeitgleiches Schalten der Leistungshalbleiterbauelemente erreichbar ist.

Nach einer weiteren Ausgestaltung der Erfindung ist eine mit der Schaltzeitpunktschaltung über eine dritte Leitung verbundene Steuerschaltung zur Erzeugung von Steuersignalen zum Ansteuern der Schaltzeitpunktsteuerung vorgesehen. Bei der Steuerschaltung kann es sich um ein separates Modul handeln, welches über eine geeignete Schnittstelle, welche Bestandteil der dritten Leitung sein kann, mit der Schaltzeitpunktschaltung verbunden ist. Die Steuerschaltung ermöglicht einen auf den jeweiligen Anwendungszweck ausgerichteten Betrieb des Leistungsteils.

Erfindungsgemäß ist die Schaltzeitpunktschaltung zur Erzeugung der individuellen Schaltsignale in Abhängigkeit des Steuersignals betreibbar, wobei zumindest einige der Schaltsignale mit einem vorgegebenen individuellen Schalt-Offset erzeugbar sind. Dabei ist der jeweilige Schalt-Offset so gewählt, dass ein, z. B. durch das Layout der Schaltungsanordnung sich ergebendes asynchrones Schaltverhalten der Leistungshalbleiterbauelemente bzw. der Module korrigiert wird. Damit kann die Temperaturbelastung der Leistungshalbleiterbauelemente durch gleichmäßige Lastverteilung reduziert und insgesamt die Zuverlässigkeit der Schaltungsanordnung verbessert werden. Eine spezifische Anpassung der Steuerschaltung ist dazu nicht unbedingt erforderlich.

Die zu kompensierende Größe kann durch ein für jeden Treiber fest vorgegebenes Schalt-Offset kompensiert werden. Zweckmäßigerweise ist eine mit der Schaltzeitpunktschaltung verbundene Messvorrichtung zur Messung der Größe an jedem der Module vorgesehen. In diesem Fall kann die Schaltzeitpunktschaltung zur Erzeugung der individuellen Schalt-Offsets in Abhängigkeit der gemessenen Größe betrieben werden. Damit kann dynamisch auf Veränderungen in der Größe reagiert werden. Das erhöht weiter die Zuverlässigkeit und damit auch die Haltbarkeit der Schaltungsanordnung.

Nach einer weiteren Ausgestaltung ist vorgesehen, dass die Schaltzeitpunktschaltung so betreibbar, dass bei Überschreiten eines für die Größe vorgegebenen Grenzwerts für das betreffende Modul kein Schaltsignal erzeugt wird. D. h. bei Überschreiten des Grenzwerts, z. B. einer vorgegebenen Temperatur, wird das Modul nicht mehr angesteuert, um eine Überlastung und eine dadurch möglicherweise bedingte Zerstörung zu vermeiden. Alternativ dazu ist es auch möglich, das betreffende Modul mit einer verkürzten Schaltdauer zu betreiben, z. B. später ein- und/oder früher auszuschalten als die anderen Module.

Insbesondere in diesem Fall ist es vorteilhaft, dass die Schaltzeitpunktschaltung zur Erzeugung einer Fehlermeldung bei Überschreiten des Grenzwerts betreibbar ist. Die Fehlermeldung kann von der Steuerschaltung erfasst und es kann ggf. einem Benutzer eine verminderte Leistung oder ein bevorstehender Ausfall der Schaltungsanordnung angezeigt werden.

Die mit der Messeinrichtung gemessene Größe ist vorteilhafterweise eine Temperatur des Moduls und/oder ein vom Modul erzeugter Strom. Die Schaltzeitpunktschaltung kann zur Bestimmung eines die aktuelle Last des Moduls wiedergebenden Lastwerts den von der Messeinrichtung gemessenen Messwerten betreibbar sein. D. h. es kann ein eine aktuelle Last des Moduls wiedergebender Lastwert bestimmt werden. Das ermöglicht eine genaue Einstellung des jeweiligen Schalt-Offsets. Der Lastwert kann auch an die Steuerschaltung übermittelt werden. Er kann zu Anzeige-, Steuer- oder Regelzwecken verwendet werden.

Des Weiteren ist es zweckmäßig, dass bei zumindest einem Modul sämtliche Leistungshalbleiterbauelemente mit dem Treiber über gleich lange erste Leitungen verbunden sind. Damit wird die Ausbildung unterschiedlicher parasitärer Induktivitäten vermieden. Zweckmäßigerweise sind die Module baugleich ausgeführt. Das vereinfacht die Herstellung der Schaltungsanordnung.

Jeder Treiber ist zweckmäßigerweise mit einer Stromversorgung verbunden. Die Stromversorgung dient der Bereitstellung der zum Schalten der Leistungshalbleiterbauelemente erforderlichen Spannung im Bereich von 8 bei 20 Volt. Die Steuer- und/oder Schaltsignale weisen dagegen vorteilhafterweise eine geringere Spannung von 1,5 bis 5 Volt auf.

Nach weiterer Maßgabe der Erfindung wird ein Verfahren zum Betreiben einer Leistungshalbleiterschaltung vorgeschlagen, umfassend
mehrere Module, bei denen jeweils ein Treiber mit zumindest einem Leistungshalbleiterbauelement über zumindest eine erste Leitung verbunden ist,
wobei mittels einer mit den Treibern über zweite Leitungen verbundenen Schaltzeitpunktschaltung für jeden der Treiber ein individuelles Schaltsignal erzeugt wird, wobei jedes der Schaltsignale für den jeweiligen Treiber individuell bezüglich des Schaltzeitpunkts ist, wobei die Schaltzeitpunktschaltung zur Erzeugung der individuellen Schaltsignale in Abhängigkeit eines Steuersignals betrieben wird, wobei zumindest einige der Schaltsignale mit einem vorgegebenen individuellen Schalt-Offset erzeugt werden, wobei der jeweilige Schalt-Offset so gewählt ist, dass ein sich ergebendes asynchrones Schaltverhalten der Leistungshalbleiterbauelemente korrigiert wird.

Wegen der Vorteile des Verfahrens sowie dessen Ausgestaltungen wird auf die vorangegangenen Ausführungen zur Vorrichtung verwiesen. Die dort beschriebenen Merkmale gelten in gleicher Weise für das Verfahren.

Nachfolgend werden anhand der Zeichnung Ausführungsbeispiele der Erfindung näher erläutert. Es zeigen:
- Fig. 1: ein Beispiel einer erfindungsgemäßen Schaltungsanordnung,
- Fig. 2a: ein von einer Steuerschaltung erzeugtes Steuersignal über der Zeit und
- Fig. 2b-e: mit der Schaltzeitpunktschaltung erzeugte Schaltsignale über der Zeit.

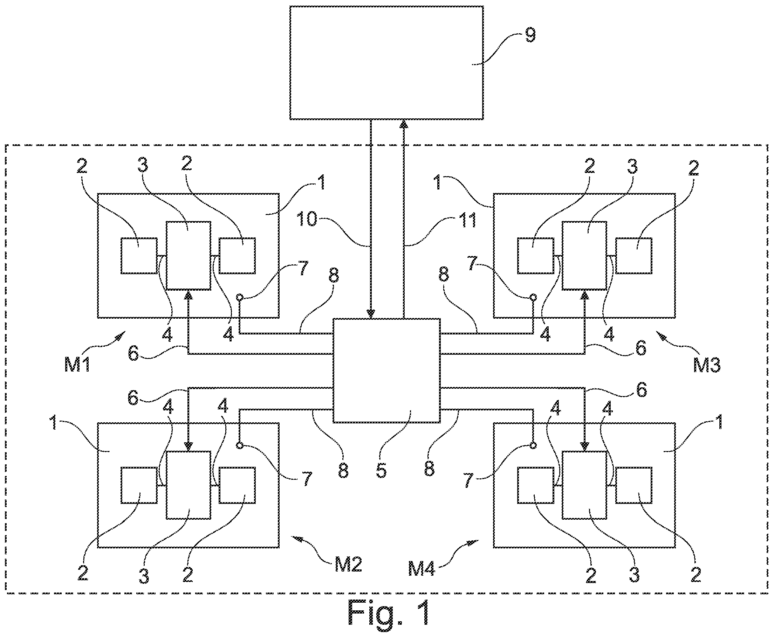

In Fig. 1 umfasst ein durch die unterbrochene Linie kenntlich gemachtes Leistungsteil mehrere Module M1-M4. Die Module M1-M4 sind vorteilhafterweise baugleich ausgeführt. Jedes der Module M1-M4 weist z. B. ein DCB-Substrat 1 auf, auf dem mehrere Leistungshalbleiterbauelemente 2, beispielsweise IGBTs, aufgenommen sind. Mit dem Bezugszeichen 3 sind Treiber bzw. Leistungstreiber bezeichnet, die z. B. aus ICs gebildet sein können. Die Treiber 3 sind jeweils über gleichlange Gateleitungen bzw. erste Leitungen 4 mit den Leistungshalbleiterbauelementen 2 verbunden.

Mit dem Bezugszeichen 5 ist eine Schaltzeitpunktschaltung bezeichnet, welche beispielsweise nach Art eines Mikrocontrollers ausgebildet ist. Die Schaltzeitpunktschaltung 5 ist mit jedem der Treiber 3 über jeweils eine zweite Leitung 6 verbunden.

An jedem der Module M1-M4 ist jeweils eine Temperaturmesseinrichtung 7, z. B. ein Thermoelement, angebracht, welches über eine Messleitung 8 mit der Schaltzeitpunktschaltung 5 verbunden ist. Mit dem Bezugszeichen 9 ist eine Steuerschaltung bezeichnet, welche eine separate Baugruppe bildet und mit dem Leistungsteil elektrisch leitend verbunden sein kann. Eine dritte Leitung zum Übermitteln von Steuersignalen von der Steuerschaltung zur Schaltzeitpunktschaltung 5 ist mit dem Bezugszeichen 10 bezeichnet. Über eine vierte Leitung 11 können von der Schaltzeitpunktschaltung 5 beispielsweise Fehlermeldungen, Lastwerte oder dgl. an die Steuerschaltung 9 übermittelt werden.

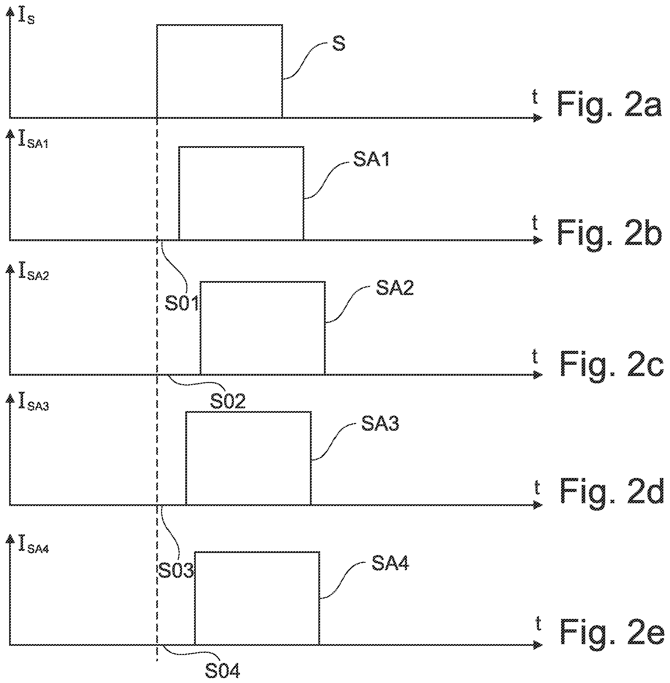

Die Funktion der in der Fig. 1 gezeigten Schaltungsanordnung wird nunmehr in Zusammensicht mit den Fig. 2a bis 2e näher erläutert.

Von der Steuerschaltung 9 werden Steuersignale S erzeugt, von denen eines beispielhaft in Fig. 2a gezeigt ist. Es handelt sich dabei beispielhaft um ein Rechtecksignal als Teil eines PMW-Signals.

Auf der Grundlage des Steuersignals S werden von der Schaltzeitpunktschaltung 5 für jeden der Treiber 3 jeweils ein individuelles Schaltsignal SA1, SA2, SA3, SA4 erzeugt. Die Schaltsignale SA1, SA2, SA3, SA4 werden zeitlich versetzt mit einem Schalt-Offset SO1, SO1, SO3, SO4 erzeugt. Durch den Schalt-Offset SO1, SO2, SO3, SO4 werden beispielsweise durch das Layout der Schaltungsanordnung bedingte Schaltzeitverzögerungen kompensiert und damit z. B. ein zeitgleiches Schalten der Leistungshalbleiterbauelemente 2 erreicht. Es können durch ein zeitversetztes Schalten der Leistungshalbleiterbauelemente 2 bedingte Temperaturerhöhungen vermieden und damit die Zuverlässigkeit der Schaltungsanordnung verbessert werden.

Der Schalt-Offset SO1, SO2, SO3, SO4 kann ein fest vorgegebener Wert sein. Der Schalt-Offset SO1, SO2, SO3, SO4 kann aber auch dynamisch eingestellt werden. Die Einstellung kann beispielsweise in Abhängigkeit gemessener Größen erfolgen. Beispielsweise kann mit der Temperaturmesseinrichtung 7 die Temperatur jedes der Module M1-M4 erfasst werden. Als weitere Größe kann beispielsweise ein von jedem der Module M1-M4 gelieferter Ausgangsstrom zur Ermittlung eines geeigneten Lastwerts gemessen werden. In die Ermittlung des Lastwerts können auch andere Parameter eingehen, welche beispielsweise eine Alterung der Leistungshalbleiterbauelemente 2 beschreiben. In Abhängigkeit des kalkulierten Lastwerts kann der Schalt-Offset SO1, SO2, SO3, SO4 in geeigneter Weise so eingestellt werden, dass über einen breiten Betriebsbereich hinweg ein optimales Schaltverhalten der Leistungshalbleiterbauelemente 2 geleistet wird.

Ferner kann für den Lastwert ein Grenz- bzw. Schwellwert definiert werden. Bei Erreichen des Grenzwerts kann mittels der Schaltzeitpunktschaltung 5 eine Ansteuerung des jeweiligen Moduls M1-M4 unterbrochen werden. Damit kann eine Überlastung des jeweiligen Moduls M1-M4 und eine dadurch bedingte Zerstörung vermieden werden. In diesem Fall kann ein Fehlersignal über die vierte Leitung 11 der Steuerschaltung 9 zur Verfügung gestellt werden.

Schließlich ist es auch möglich, den Ein- und Ausschaltzeitpunkte für jedes Modul mittels der Schaltzeitpunktschaltung 5 so zu steuern und/oder regeln, dass eine Schaltdauer, beispielsweise in Abhängigkeit der gemessenen Größe, variiert wird. Die Schaltdauer kann dabei so eingestellt werden, dass beispielsweise die Temperatur des Moduls in einem vorgegebenen Bereich gehalten wird.

### Bezugszeichenliste

- 1: DCB-Substrat
- 2: Leistungshalbleiterbauelement
- 3: Treiber
- 4: erste Leitung
- 5: Schaltzeitpunktschaltung
- 6: zweite Leitung
- 7: Temperaturmesseinrichtung
- 8: Messleitung
- 9: Steuerschaltung
- 10: dritte Leitung
- 11: vierte Leitung
- M1, M2, M3, M4: Modul
- S: Steuersignal
- SA1, SA2, SA3, SA4: Schaltsignal
- SO1, SO2, SO3, SO4: Schalt-Offset

## Patentansprüche

1. Schaltungsanordnung für Leistungshalbleiterbauelemente (2), umfassend
mehrere Module (M1, M2, M3, M4), bei denen jeweils ein Treiber (3) mit zumindest einem Leistungshalbleiterbauelement (2) über zumindest eine erste Leitung (4) verbunden ist,
wobei eine mit den Treibern (3) über zweite Leitungen (6) verbundene Schaltzeitpunktschaltung (5) vorgesehen ist, mit der für jeden der Treiber (3) ein individuelles Schaltsignal (SA1, SA2, SA3, SA4) erzeugbar ist, wobei jedes der Schaltsignale (SA1, SA2, SA3, SA4) für den jeweiligen Treiber (3) individuell bezüglich des Schaltzeitpunkts ist, wobei die Schaltzeitpunktschaltung (5) zur Erzeugung der individuellen Schaltsignale (SA1, SA2, SA3, SA4) in Abhängigkeit eines Steuersignals (S) betreibbar ist, wobei zumindest einige der Schaltsignale mit einem vorgegebenen individuellen Schalt-Offset (SO1, S02, S03, S04) erzeugbar sind, wobei der jeweilige Schalt-Offset (SO1, S02, S03, S04) so gewählt ist, dass ein sich ergebendes asynchrones Schaltverhalten der Leistungshalbleiterbauelemente (2) korrigiert wird.

2. Schaltungsanordnung nach Anspruch 1, wobei die mit der Schaltzeitpunktschaltung (5) erzeugten Schaltsignale (SA1, SA2, SA3, SA4) zeitlich so aufeinander abstimmbar sind, dass zumindest eine den Schaltzeitpunkt der Leistungshalbleiterbauelemente (2) beeinflussende Größe kompensierbar und ein zeitgleiches Schalten der Leistungshalbleiterbauelemente (2) erreichbar ist.

3. Schaltungsanordnung nach Anspruch 1 oder 2, wobei eine mit der Schaltzeitpunktschaltung (5) über eine dritte Leitung (10) verbundene Steuerschaltung (9) zur Erzeugung von Steuersignalen (S) zum Ansteuern der Schaltzeitpunktsteuerung (5) vorgesehen ist.

4. Schaltungsanordnung nach Anspruch 2, wobei an jedem der Module (M1, M2, M3, M4) eine mit Schaltzeitpunktschaltung verbundene Messvorrichtung (7) zur Messung der Größe vorgesehen ist.

5. Schaltungsanordnung nach Anspruch 4, wobei die Schaltzeitpunktschaltung (5) zur Erzeugung der individuelle Schalt-Offsets (SO1, S02, SO3, S04) in Abhängigkeit der gemessenen Größe betreibbar ist.

6. Schaltungsanordnung nach Anspruch 2, wobei die Schaltzeitpunktschaltung (5) so betreibbar ist, dass bei Überschreiten eines für die Größe vorgegebenen Grenzwerts für das betreffende Modul (M1, M2, M3, M4) kein Schaltsignal erzeugt wird.

7. Schaltungsanordnung nach Anspruch 6, wobei die Schaltzeitpunktschaltung (5) zur Erzeugung einer Fehlermeldung bei Überschreiten des Grenzwerts betreibbar ist.

8. Schaltungsanordnung nach einem der Ansprüche 4 oder 5, wobei die mit der Messeinrichtung (7) gemessene Größe eine Temperatur des Moduls (M1, M2, M3, M4) und/oder ein vom Modul (M1, M2, M3, M4) erzeugter Strom ist.

9. Schaltungsanordnung nach einem der Ansprüche 4, 5 oder 8, wobei die Schaltzeitpunktschaltung zur Bestimmung eines eine aktuelle Last des Moduls (M1, M2, M3, M4) wiedergebenden Lastwerts aus den von der Messeinrichtung (7) gemessenen Messwerten betreibbar ist.

10. Schaltungsanordnung nach einem der vorhergehenden Ansprüche, wobei bei zumindest einem Modul (M1, M2, M3, M4) mehrere Leistungshalbleiterbauelemente (2) mit dem Treiber (3) über gleich lange erste Leitungen (4) verbunden sind.

11. Schaltungsanordnung nach einem der vorhergehenden Ansprüche, wobei die Module (M1, M2, M3, M4) baugleich ausgeführt sind.

12. Schaltungsanordnung nach einem der vorhergehenden Ansprüche, wobei jeder Treiber (3) mit einer Stromversorgung verbunden ist.

13. Schaltungsanordnung nach einem der vorhergehenden Ansprüche, wobei die Steuer- (S) und/oder Schaltsignale (SA1, SA2, SA3, SA4) eine Spannung von 1,5 bis 5 V aufweisen.

14. Verfahren zum Betrieben einer Leistungshalbleiterschaltung, umfassend
mehrere Module (M1, M2, M3, M4), bei denen jeweils ein Treiber (3) mit zumindest einem Leistungshalbleiterbauelement (2) über zumindest eine erste Leitung (4) verbunden ist,
wobei mittels einer mit den Treibern (3) über zweite Leitungen (6) verbundenen Schaltzeitpunktschaltung (5) für jeden der Treiber (3) ein individuelles Schaltsignal (SA1, SA2, SA3, SA4) erzeugt wird, wobei jedes der Schaltsignale (SA1, SA2, SA3, SA4) für den jeweiligen Treiber (3) individuell bezüglich des Schaltzeitpunkts ist, wobei die Schaltzeitpunktschaltung (5) zur Erzeugung der individuellen Schaltsignale (SA1, SA2, SA3, SA4) in Abhängigkeit eines Steuersignals (S) betrieben wird, wobei zumindest einige der Schaltsignale mit einem vorgegebenen individuellen Schalt-Offset (SO1, S02, SO3, S04) erzeugt werden, wobei der jeweilige Schalt-Offset (SO1, S02, SO3, S04) so gewählt ist, dass ein sich ergebendes asynchrones Schaltverhalten der Leistungshalbleiterbauelemente (2) korrigiert wird.

15. Verfahren nach Anspruch 14, wobei die mit der Schaltzeitpunktschaltung (5) erzeugten Schaltsignale (SA1, SA2, SA3, SA4) zeitlich so aufeinander abgestimmt werden, dass zumindest eine den Schaltzeitpunkt der Leistungshalbleiterbauelemente (2) beeinflussende Größe kompensiert und ein zeitgleiches Schalten der Leistungshalbleiterbauelemente (2) erreicht wird.

16. Verfahren nach Anspruch 14 oder 15, wobei eine mit der Schaltzeitpunktschaltung (5) über eine dritte Leitung (10) verbundene Steuerschaltung (9) zur Erzeugung von Steuersignalen (S) zum Ansteuern der Schaltzeitpunktsteuerung (5) vorgesehen ist, und wobei mittels der Schaltzeitpunktschaltung (5) die individuellen Schaltsignale (SA1, SA2, SA3, SA4) in Abhängigkeit des Steuersignals (S) erzeugt werden.

17. Verfahren nach einem der Ansprüche 14 bis 16, wobei die Größe an jedem der Module (M1, M2, M3, M4) mittels einer mit Schaltzeitpunktschaltung verbundenen Messvorrichtung (7) gemessen wird.

18. Verfahren nach Anspruch 17, wobei mittels der Schaltzeitpunktschaltung (5) die individuellen Schalt-Offsets (SO1, S02, S03, S04) in Abhängigkeit der gemessenen Größe erzeugt werden.

19. Verfahren nach Anspruch 15, wobei bei Überschreiten eines für die Größe vorgegebenen Grenzwerts für das betreffende Modul (M1, M2, M3, M4) kein Schaltsignal erzeugt wird.

20. Verfahren nach einem der Anspruch 19, wobei mittels der Schaltzeitpunktschaltung (5) bei Überschreiten des Grenzwerts eine Fehlermeldung erzeugt wird.

21. Verfahren nach einem der Ansprüche 17 oder 18, wobei die mit der Messeinrichtung (7) als Größe eine Temperatur des Moduls (M1, M2, M3, M4) und/oder ein vom Modul (M1, M2, M3, M4) erzeugter Strom gemessen wird.

22. Verfahren nach einem der Ansprüche 17, 18 oder 21, wobei ein eine aktuelle Last des Moduls (M1, M2, M3, M4) wiedergebenden Lastwerts aus den von der Messeinrichtung (7) gemessenen Messwerten bestimmt wird.

23. Verfahren nach einem der Ansprüche 14 bis 22, wobei bei zumindest einem Modul (M1, M2, M3, M4) zur Verbindung mehrerer Leistungshalbleiterbauelemente (2) mit dem Treiber (3) gleich lange erste Leitungen (4) verwendet werden.

24. Verfahren nach einem der Ansprüche 14 bis 23, wobei baugleich ausgeführte Module (M1, M2, M3, M4) verwendet werden.

## Claims

1. Circuit arrangement for power semiconductor components (2), comprising
multiple modules (M1, M2, M3, M4), each of which has a driver (3) connected to at least one power semiconductor component (2) via at least one first line (4),
wherein there is provision for a switching time circuit (5), which is connected to the drivers (3) via second lines (6) and by means of which an individual switching signal (SA1, SA2, SA3, SA4) is generable for each of the drivers (3), wherein each of the switching signals (SA1, SA2, SA3, SA4) is individual to the respective driver (3) in respect of the switching time, wherein the switching time circuit (5) is operable for the purpose of generating the individual switching signals (SA1, SA2, SA3, SA4) on the basis of a control signal (S), wherein at least some of the switching signals are generable with a prescribed individual switching offset (SO1, SO2, SO3, SO4), wherein the respective switching offset (SO1, SO2, SO3, SO4) is chosen such that a resultant asynchronous switching response of the power semiconductor components (2) is corrected.

2. Circuit arrangement according to Claim 1, wherein the switching signals (SA1, SA2, SA3, SA4) generated using the switching time circuit (5) are temporally tuneable with one another such that at least one variable influencing the switching time of the power semiconductor components (2) is able to be compensated for and simultaneous switching of the power semiconductor components (2) is achievable.

3. Circuit arrangement according to Claim 1 or 2, wherein there is provision for a control circuit (9) connected to the switching time circuit (5) via a third line (10) for the purpose of generating control signals (S) for actuating the switching time controller (5).

4. Circuit arrangement according to Claim 2, wherein there is provision on each of the modules (M1, M2, M3, M4) for a measuring apparatus (7) connected to the switching time circuit for the purpose of measuring the variable.

5. Circuit arrangement according to Claim 4, wherein the switching time circuit (5) is operable for the purpose of producing the individual switching offsets (SO1, SO2, SO3, SO4) on the basis of the measured variable.

6. Circuit arrangement according to Claim 2, wherein the switching time circuit (5) is operable such that a switching signal is not generated for the relevant module (M1, M2, M3, M4) if a limit value prescribed for the variable is exceeded.

7. Circuit arrangement according to Claim 6, wherein the switching time circuit (5) is operable for the purpose of producing an error message when the limit value is exceeded.

8. Circuit arrangement according to either of Claims 4 and 5, wherein the variable measured by means of the measuring device (7) is a temperature of the module (M1, M2, M3, M4) and/or a current produced by the module (M1, M2, M3, M4).

9. Circuit arrangement according to one of Claims 4, 5 and 8, wherein the switching time circuit is operable for the purpose of determining a load value reproducing a present load of the module (M1, M2, M3, M4) from the measured values measured by the measuring device (7).

10. Circuit arrangement according to one of the preceding claims, wherein at least one module (M1, M2, M3, M4) has multiple power semiconductor components (2) connected to the driver (3) via first lines (4) of equal length.

11. Circuit arrangement according to one of the preceding claims, wherein the modules (M1, M2, M3, M4) are embodied in physically identical fashion.

12. Circuit arrangement according to one of the preceding claims, wherein each driver (3) is connected to a power supply.

13. Circuit arrangement according to one of the preceding claims, wherein the control (S) and/or switching signals (SA1, SA2, SA3, SA4) have a voltage of between 1.5 and 5 V.

14. Method for operating a power semiconductor circuit, comprising
multiple modules (M1, M2, M3, M4), each of which has a driver (3) connected to at least one power semiconductor component (2) via at least one first line (4),
wherein an individual switching signal (SA1, SA2, SA3, SA4) is generated for each of the drivers (3) by means of a switching time circuit (5), which is connected to the drivers (3) via second lines (6), wherein each of the switching signals (SA1, SA2, SA3, SA4) is individual to the respective driver (3) in respect of the switching time, wherein the switching time circuit (5) is operated for the purpose of generating the individual switching signals (SA1, SA2, SA3, SA4) on the basis of a control signal (S), wherein at least some of the switching signals are generated with a prescribed individual switching offset (SO1, SO2, SO3, SO4), wherein the respective switching offset (SO1, SO2, SO3, SO4) is chosen such that a resultant asynchronous switching response of the power semiconductor components (2) is corrected.

15. Method according to Claim 14, wherein the switching signals (SA1, SA2, SA3, SA4) generated using the switching time circuit (5) are temporally coordinated with one another such that at least one variable influencing the switching time of the power semiconductor components (2) is compensated for and simultaneous switching of the power semiconductor components (2) is achieved.

16. Method according to Claim 14 or 15, wherein there is provision for a control circuit (9) connected to the switching time circuit (5) via a third line (10) for the purpose of generating control signals (S) for actuating the switching time controller (5), and wherein the individual switching signals (SA1, SA2, SA3, SA4) are generated by means of the switching time circuit (5) on the basis of the control signal (S).

17. Method according to one of Claims 14 to 16, wherein the variable is measured on each of the modules (M1, M2, M3, M4) by means of a measuring apparatus (7) connected to the switching time circuit.

18. Method according to Claim 17, wherein the individual switching offsets (SO1, SO2, SO3, SO4) are produced by means of the switching time circuit (5) on the basis of the measured variable.

19. Method according to Claim 15, wherein a switching signal is not generated for the relevant module (M1, M2, M3, M4) if a limit value prescribed for the variable is exceeded.

20. Method according to Claim 19, wherein an error message is produced by means of the switching time circuit (5) when the limit value is exceeded.

21. Method according to either of Claims 17 and 18, wherein the variable measured by means of the measuring device (7) is a temperature of the module (M1, M2, M3, M4) and/or a current produced by the module (M1, M2, M3, M4) .

22. Method according to one of Claims 17, 18 and 21, wherein a load value reproducing a present load of the module (M1, M2, M3, M4) is determined from the measured values measured by the measuring device (7).

23. Method according to one of Claims 14 to 22, wherein at least one module (M1, M2, M3, M4) has first lines (4) of equal length used to connect multiple power semiconductor components (2) to the driver (3).

24. Method according to one of Claims 14 to 23, wherein modules (M1, M2, M3, M4) embodied in physically identical fashion are used.

## Revendications

1. Arrangement de circuit pour composants semiconducteurs de puissance (2), comprenant
plusieurs modules (M1, M2, M3, M4), au niveau desquels un circuit d'attaque (3) est respectivement relié à au moins un composant semiconducteur de puissance (2) par le biais d'au moins une première ligne (4),
un circuit d'instant de commutation (5) relié aux circuits d'attaque (3) par le biais de deux lignes (6) étant présent, lequel permet de générer un signal de commutation (SA1, SA2, SA3, SA4) individuel pour chacun des circuits d'attaque (3), chacun des signaux de commutation (SA1, SA2, SA3, SA4) étant individuel pour le circuit d'attaque (3) respectif pour ce qui concerne l'instant de commutation, le circuit d'instant de commutation (5) pouvant être utilisé pour générer les signaux de commutation (SA1, SA2, SA3, SA4) individuels en fonction d'un signal de commande (S), au moins certains des signaux de commutation pouvant être générés avec un décalage de commutation (SO1, SO2, SO3, SO4) individuel prédéfini, le décalage de commutation (SO1, SO2, SO3, SO4) étant choisi de telle sorte qu'un comportement de commutation asynchrone résultant des composants semiconducteurs de puissance (2) est corrigé.

2. Arrangement de circuit selon la revendication 1, les signaux de commutation (SA1, SA2, SA3, SA4) générés avec le circuit d'instant de commutation (5) pouvant être synchronisés entre eux de telle sorte qu'il est possible de compenser au moins une grandeur qui influence l'instant de commutation des composants semiconducteurs de puissance (2) et d'obtenir une commutation simultanée des composants semiconducteurs de puissance (2).

3. Arrangement de circuit selon la revendication 1 ou 2, un circuit de commande (9) relié au circuit d'instant de commutation (5) par le biais d'une troisième ligne (10) étant présent pour générer des signaux de commande (S) destinés à commander le contrôleur d'instant de commutation (5).

4. Arrangement de circuit selon la revendication 2, un dispositif de mesure (7) relié au circuit d'instant de commutation et destiné à mesurer la grandeur étant présent au niveau de chaque module (M1, M2, M3, M4).

5. Arrangement de circuit selon la revendication 4, le circuit d'instant de commutation (5) pouvant être utilisé pour générer les décalages de commutation (SO1, SO2, SO3, SO4) individuels en fonction de la grandeur mesurée.

6. Arrangement de circuit selon la revendication 2, le circuit d'instant de commutation (5) pouvant être utilisé de telle sorte qu'aucun signal de commutation n'est généré pour le module (M1, M2, M3, M4) concerné en cas de dépassement d'une valeur limite prédéfinie pour la grandeur.

7. Arrangement de circuit selon la revendication 6, le circuit d'instant de commutation (5) pouvant être utilisé pour générer un message d'erreur en cas de dépassement de la valeur limite.

8. Arrangement de circuit selon l'une des revendications 4 et 5, la grandeur mesurée avec le dispositif de mesure (7) étant une température du module (M1, M2, M3, M4) et/ou un courant généré par le module (M1, M2, M3, M4).

9. Arrangement de circuit selon l'une des revendications 4, 5 et 8, le circuit d'instant de commutation pouvant être utilisé pour déterminer une valeur de charge restituant une charge actuelle du module (M1, M2, M3, M4) à partir des valeurs de mesure mesurées par le dispositif de mesure (7).

10. Arrangement de circuit selon l'une des revendications précédentes, au niveau d'au moins un module (M1, M2, M3, M4), plusieurs composants semiconducteurs de puissance (2) étant reliés au circuit d'attaque (3) par des premières lignes (4) de même longueur.

11. Arrangement de circuit selon l'une des revendications précédentes, les modules (M1, M2, M3, M4) étant de construction identique.

12. Arrangement de circuit selon l'une des revendications précédentes, chaque circuit d'attaque (3) étant relié à une alimentation électrique.

13. Arrangement de circuit selon l'une des revendications précédentes, les signaux de commande (S) et/ou de commutation (SA1, SA2, SA3, SA4) possédant une tension de 1,5 à 5 V.

14. Procédé pour faire fonctionner un circuit de semiconducteurs de puissance, comprenant
plusieurs modules (M1, M2, M3, M4), au niveau desquels un circuit d'attaque (3) est respectivement relié à au moins un composant semiconducteur de puissance (2) par le biais d'au moins une première ligne (4),
un signal de commutation (SA1, SA2, SA3, SA4) individuel pour chacun des circuits d'attaque (3) étant généré au moyen d'un circuit d'instant de commutation (5) relié aux circuits d'attaque (3) par le biais de deux lignes (6), chacun des signaux de commutation (SA1, SA2, SA3, SA4) étant individuel pour le circuit d'attaque (3) respectif pour ce qui concerne l'instant de commutation, le circuit d'instant de commutation (5) étant utilisé pour générer les signaux de commutation (SA1, SA2, SA3, SA4) individuels en fonction d'un signal de commande (S), au moins certains des signaux de commutation étant générés avec un décalage de commutation (SO1, SO2, SO3, SO4) individuel prédéfini, le décalage de commutation (SO1, SO2, SO3, SO4) étant choisi de telle sorte qu'un comportement de commutation asynchrone résultant des composants semiconducteurs de puissance (2) est corrigé.

15. Procédé selon la revendication 14, les signaux de commutation (SA1, SA2, SA3, SA4) générés avec le circuit d'instant de commutation (5) étant synchronisés entre eux de telle sorte qu'au moins une grandeur qui influence l'instant de commutation des composants semiconducteurs de puissance (2) est compensée et une commutation simultanée des composants semiconducteurs de puissance (2) est obtenue.

16. Procédé selon la revendication 14 ou 15, un circuit de commande (9) relié au circuit d'instant de commutation (5) par le biais d'une troisième ligne (10) étant présent pour générer des signaux de commande (S) destinés à commander le contrôleur d'instant de commutation (5), et les signaux de commutation (SA1, SA2, SA3, SA4) individuels étant générés au moyen du circuit d'instant de commutation (5) en fonction du signal de commande (S).

17. Procédé selon l'une des revendications 14 à 16, la grandeur au niveau de chaque module (M1, M2, M3, M4) étant mesurée au moyen d'un dispositif de mesure (7) relié au circuit d'instant de commutation.

18. Procédé selon la revendication 17, les décalages de commutation (SO1, SO2, SO3, SO4) individuels étant générés au moyen du circuit d'instant de commutation (5) en fonction de la grandeur mesurée.

19. Procédé selon la revendication 15, aucun signal de commutation n'étant généré pour le module (M1, M2, M3, M4) concerné en cas de dépassement d'une valeur limite prédéfinie pour la grandeur.

20. Procédé selon l'une de la revendication 19, un message d'erreur étant généré au moyen du circuit d'instant de commutation (5) en cas de dépassement de la valeur limite.

21. Procédé selon l'une des revendications 17 et 18, la grandeur mesurée le avec le dispositif de mesure (7) étant une température du module (M1, M2, M3, M4) et/ou un courant généré par le module (M1, M2, M3, M4).

22. Procédé selon l'une des revendications 17, 18 ou 21, une valeur de charge restituant une charge actuelle du module (M1, M2, M3, M4) étant déterminée à partir des valeurs de mesure mesurées par le dispositif de mesure (7) .

23. Procédé selon l'une des revendications 14 à 22, des premières lignes (4) de même longueur étant utilisées au niveau d'au moins un module (M1, M2, M3, M4) pour relier plusieurs composants semiconducteurs de puissance (2) au circuit d'attaque (3).

24. Procédé selon l'une des revendications 14 à 23, des modules (M1, M2, M3, M4) de construction identique étant utilisés.
